(19) Europäisches Patentamt / European Patent Office / Office européen des brevets

(11) EP 4 776 784 A1

(12) EUROPEAN PATENT APPLICATION

(43) Date of publication:
15.07.2026 Bulletin 2026/29

(21) Application number: 25305032.2

(22) Date of filing: 13.01.2025

(51) International Patent Classification (IPC):
H10D 1/00 (2025.01)      H10D 1/66 (2025.01)
H10D 1/68 (2025.01)      H10D 62/83 (2025.01)
H10D 64/20 (2025.01)

(52) Cooperative Patent Classification (CPC):
H10D 1/66; H10D 1/047; H10D 1/716;
H10D 62/8303; H10D 64/20

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicants:
• Murata Manufacturing Co., Ltd.
  Nagaokakyo-shi, Kyoto 617-8555 (JP)
• Commissariat à l'Energie Atomique et aux
  Energies
  Alternatives
  75015 Paris (FR)

(72) Inventors:
• BUFFLE, Larry
  14000 CAEN (FR)
• VOIRON, Frédéric
  14000 CAEN (FR)
• POMORSKI, Michal
  91191 Gif-sur-Yvette Cedex (FR)
• TRUFFET, Baptiste
  91191 Gif-sur-Yvette Cedex (FR)

(74) Representative: Cabinet Beau de Loménie
103, rue de Grenelle
75340 Paris Cedex 07 (FR)

(54) A MULTI-LAYER ELECTRICAL DEVICE COMPRISING A CURVED SHAPE ELECTRODE TERMINATION

(57) An electrical device comprising,
- a substrate region (100),
- a first electrode formed in a first doped diamond layer (101), on the substrate region (100),
- a dielectric layer (102, 105, 106, 108, 110, 104, 107) on the first doped diamond layer (101) comprising two adjacent regions, a first region called intermediate layer (102, 105, 106, 108, 110) formed in a dielectric diamond material layer and a second region (104, 107) formed in a dielectric material,
- a second electrode formed in a conductor material layer (103, 113, 123, 133), located on the dielectric layer, wherein
- said first region in the dielectric diamond material having a first constant thickness
- the second region comprises a dielectric material and has an increasing thickness from said first constant thickness on the intermediate layer (102, 105, 106, 108, 110) side to a second thickness on its other side opposite to the intermediate layer, said increase of thickness having a curved shape,
- the second electrode (103, 113, 123, 133) comprises a first region (103a) having a first constant thickness above the intermediate layer (102, 105, 106, 108, 110) and a termination region (103b, 113b) extending the first region in a curved shape above the dielectric material.

FIG. 2

## Description

<u>Field of the Invention</u>

The present invention relates to the field of integration and, more particularly, to electronic products, related semiconductor products, and their methods of manufacture.

<u>Technical Background</u>

In the emerging field of high-voltage capacitor applications (e.g., operating/breakdown voltages from around 500 V to greater than 1 kV), a main concern is preventing early failures and/or premature wear out of the capacitor device due to the high voltage operation. This concern means that the operating electric field must be guaranteed with a sufficient margin for the desired lifetime of the device.

In semiconductor device electrode terminations, charge concentration effects occur due to the sharp corners or edges of the device structure. These geometric features cause the electric field to become highly non-uniform, leading to regions of charge crowding near the edges of the electrode.

This phenomenon is a result of the fundamental behavior of electric fields: they tend to concentrate at points of high curvature. When the electric field intensity at these concentrated regions exceeds the breakdown strength of the material, it can trigger premature breakdown, significantly reducing the device's voltage handling capability.

To mitigate this, specialized termination techniques are employed, such as:

1. Field Plate Termination: Uses a conductive plate to spread the electric field over a larger region.
2. Junction Termination Extension (JTE): Introduces doped regions to create a more gradual electric field gradient.
3. Guard Rings: Adds additional concentric rings around the junction to distribute the field more evenly.
4. Beveled/step mesa: A beveled/step mesa is a structure where the junction or the semiconductor surface is shaped with an inclined slope, creating an angle relative to the flat surface of the device.

These strategies are essential to ensure reliable high-voltage operation and to optimize the performance of power semiconductor devices,

Diamond, with its exceptional properties, is emerging as a promising material in semiconductor technologies. Featuring an ultra wide bandgap (~5.5 eV), unparalleled thermal conductivity, and high resistance to electric fields, it outperforms materials like silicon or silicon carbide in demanding applications. It is used to manufacture high-power, high-frequency devices capable of withstanding extreme temperatures, making it particularly valuable in power electronics and space applications. Its ability to endure harsh conditions positions diamond as an ideal solution for the future of advanced electronic components.

The current prior art solutions for reducing crowding effect at electrode terminations are not efficient, when using diamond in semiconductor technologies.

Field plate termination shows a high density of defects at the dielectric/diamond interface because there is no native oxide for diamond which degrades the long-term reliability of the device.

Guard rings and junction termination extension take a relatively larger region and are complicated to integrate in a layered structure.

Beveled/step mesa are inappropriate since device simulation demonstrates that the electric field crowding is sufficiently suppressed when the mesa is deeper than the depletion region which is impossible as long as the dielectric (intrinsic layer between the two electrodes) is fully depleted over its entire thickness. In addition, extending the step to the other electrode would result in surface conduction along the vertical edge and field crowding at the edge of each electrode.

There remains a need for a solution that overcomes these defects.

<u>Summary of the Invention</u>

The present invention provides an electrical device comprising,

- a substrate region,
- a first electrode formed in a first doped diamond layer, on the substrate region,
- a dielectric layer on the first doped diamond layer comprising two adjacent regions, a first region called intermediate layer formed in a dielectric diamond material layer and a second region formed in a dielectric material,
- a second electrode formed in a conductor material layer, located on the dielectric layer,

wherein

- said first region in the dielectric diamond material having a first constant thickness
- the second region comprises a dielectric material and has an increasing thickness from said first constant thickness on the intermediate layer side to a second thickness on its other side opposite to the intermediate layer, said increase of thickness having a curved shape,
- the second electrode comprises a first region having a first constant thickness above the intermediate layer and a termination region extending the first region in a curved shape above the dielectric material.

Advantageously, the electrical device can handle the electric field at the electrode edge regions, also called termination junctions to avoid charge crowding effects. The charge crowding effect is reduced by progressively increasing the distance between the top electrode and the opposite electrode. The progressive increase in distance follows a round shape profile, also called a curved shape profile. The electric field peak induced by the edge of the termination junctions of the prior art disappears with this new geometry of a round shape profile of the termination junctions.

According to some embodiments, the termination region ends parallel to the first region when the tangent to the curved shape at the extremity point of the termination region is perpendicular to the first region.

In addition, it is important not only to suppress the edge by the curved shape. Indeed, if the electrode terminates in a region where the charge density is not null, the electric field, being equal to the charge density divided by $\varepsilon$, will diverge and will not be suppressed. In other words, the electric field is by construction directed perpendicular to the electrode. As a consequence, beyond the vertical section of the electrode (i.e. perpendicular to interface) the electric flux across the interface in between the dielectric and the bottom electrode is null in the region.

Therefore, in addition to the curved shape of part of the second electrode, it is also important to terminate the second electrode in a configuration where the electrode portion is orthogonal to the interface to avoid the electric field crowding at the termination of the electrode. This can be achieved by terminating the electrode when the tangent to the curved shape at the extremity point of the termination region is perpendicular to the first region. The electric field being equal to the charge density divided by $\varepsilon$, when the charge density is null, the electric field is null and therefore the electric field crowding is suppressed. Indeed, if the surface of the electrode is parallel to the electric field, there is no charge density.

According to some embodiments, the dielectric material is different from diamond.

When surface conduction provides applicative advantages, for instance in the case the electrical device is a lateral diode, it is advantageous to have both dielectric diamond material and dielectric material, having a different doping.

According to some embodiments, the dielectric material is diamond, the dielectric layer being a monolithic layer comprising diamond, and the second electrode is formed in a dopped diamond layer as conductor material..

This is particularly of interest as it enables to suppress the surface conduction mechanism that could be induced when having two different dielectric materials, diamond based and non-diamond based, when surface conduction is not privileged.

According to some embodiments the intermediate layer extends on the first doped diamond layer parallel to first doped diamond layer towards the extremity of the first doped diamond layer up to an ending vertical plan located between

- a vertical plan comprising the extremity of the first doped diamond layer and perpendicular to the first doped diamond layer and

    - - a vertical plan perpendicular to the first doped diamond layer and comprising the extremity of the termination region.

According to some embodiments, the curved shape is a round shaped profile and is a quarter of a circle.

In such a configuration, the space used for the electrode termination is reduced compared to another round shape profile that would extend more by having a radius which would not be constant.

According to some embodiments, the radius of the curved shape (curvature radius) is proportional to a thickness of the multi-layer device.

According to some embodiments, the curvature radius of the rounded corner is greater than a thickness of an insulator layer of the multi-layer device.

According to some embodiments, the radius of the curved shape (curvature radius) is twice the thickness of the intermediate layer. This allows having a uniform dielectric thickness

In yet another embodiment, the curvature radius of the rounded corner is greater than double a thickness of the intermediate layer (referred to first thickness in the present disclosure) of the multi-layer device.

According to some embodiments, the second doped diamond layer comprises a third region extending from the extremity of the termination region not connected to the first region, parallel to the first doped diamond layer, and separated from the first doped diamond layer by said dielectric layer.

According to some embodiments, the second doped diamond layer comprises a third region extending from the extremity of the termination region not connected to the first region and perpendicular to the first doped diamond layer.

According to some embodiments, the electrical device comprises a diamond passivation layer comprising

- a first part located above part of the second doped diamond layer first region having a third thickness, and
- a second part extending from the first part, having a fourth thickness greater than the third thickness and formed above part of the second doped diamond layer, said part comprising at least said termination region and said third region and ending after the extremity of said third region, on the first diamond layer.

The invention also provides a method of manufacturing an electrical device comprising:

- obtaining a substrate region,
- forming, by epitaxy, a first electrode in a first doped diamond layer on the substrate region,
- forming, by epitaxy, an intermediate layer of a first thickness on at least a first region of the first doped diamond layer,
- forming, a dielectric layer on at least a second region of the first doped diamond layer, of a second thickness greater than the first thickness, joining and extending the intermediate layer, said first region and said second region being adjacent,
- etching the dielectric layer, so that the non-diamond dielectric layer has an increasing thickness from said first thickness on the intermediate layer side to a second thickness on its other side, said increase of thickness having a curved shape,
- forming, a second electrode in a conductor material layer located on the non-diamond dielectric layer, so that the second electrode comprises a first region, of a first constant thickness, on the intermediate layer, and a termination region, extending the first region in a curved shape above the dielectric layer, the termination region being ended parallel to the first region when the tangent to the curved shape at the extremity point of the termination region is perpendicular to the first region.

In some embodiments, selective growth can be used instead of etching

The invention also provides a method of using an electrical device according to any of the embodiments of the present disclosure, wherein a voltage applied to the capacitor exceeds 700 V, or preferably 900 V, or even more preferably 1.2 kV.

The invention also provides a method of manufacturing an electrical device comprising:

- obtaining a substrate region,
- forming, by epitaxy, a first electrode in a first doped diamond layer on the substrate region,
- forming, by epitaxy, an intermediate layer of a first thickness on at least a first region of the first doped diamond layer,
- forming, a dielectric layer on at least a second region of the first doped diamond layer, of a second thickness greater than the first thickness, joining and extending the intermediate layer, said first region and said second region being adjacent,
- etching the dielectric layer, so that the non-diamond dielectric layer has an increasing thickness from said first thickness on the intermediate layer side to a second thickness on its other side, said increase of thickness having a curved shape,
- forming, a second electrode in a doped diamond layer located on the non-diamond dielectric layer, so that the second doped diamond layer comprises

  ○ a first region of a first constant thickness, on the intermediate layer, and
  ○ a termination region, extending the first region in a curved shape above the non-diamond dielectric layer, the termination region being ended parallel to the first region when the tangent to the curved shape at the extremity point of the termination region is perpendicular to the first region and
  ○ a third region, extending the second termination region, and located above the second region of the diamond intermediate layer,

- Forming a diamond passivation layer comprising:

  ○ - a first part located above part of the second doped diamond layer (123) first region (103a) having a third thickness, and
  ○ - a second part extending from the first part, having a fourth thickness greater than the third thickness and formed above part of the second doped diamond layer (123), said part comprising at least said termination region (103b) and said third region (123c) and ending after the extremity of said third region (123c), on the first diamond layer 101.

This method can be adapted for the manufacture of any one of the above defined devices.

Brief Description of the Drawings

Further features and advantages of the present invention will become apparent from the following description of certain embodiments thereof, given by way of illustration only, not limitation, with reference to the accompanying drawings in which:

- Figure 1a is a side view and figure 1b is a top view of a device according to a first embodiment of the present disclosure,
- Figure 2 is a side view of a device according to a second embodiment of the present disclosure,
- Figure 3 is a side view of a device according to a third embodiment of the present disclosure,
- Figure 4 is a side view of a device according to a fourth embodiment of the present disclosure,
- Figure 5 is a side view of a device according to a fifth embodiment of the present disclosure,

Figure 6 is a side view of a device according to a sixth embodiment of the present disclosure.

Detailed Description of Example Embodiments

We will now describe five different embodiments of the present disclosure.

On the following figures, only the distinguishing features of the electrical devices, and more precisely, only the layers of interest are shown and detailed on the figures.

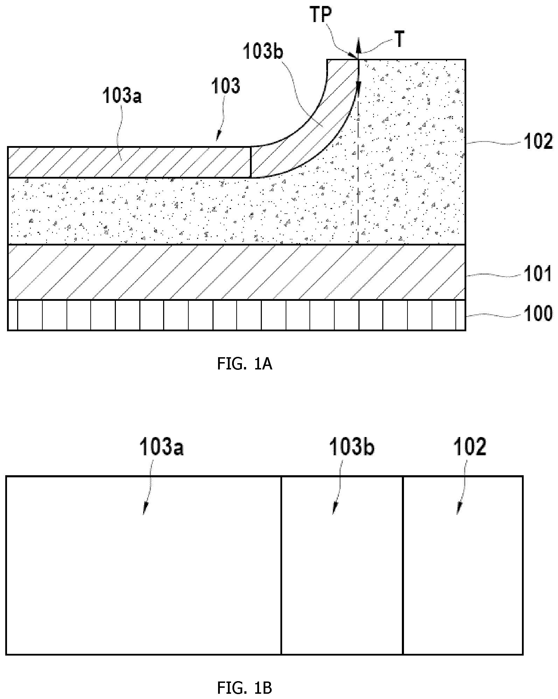

Figures 1a and 1b discloses a first embodiment of the present disclosure.

As illustrated on figure 1a, the structure of the electrical device, or multi-layer electrical device, is formed above a substrate 100 which can be a monocrystalline diamond substrate or a monocrystalline diamond layer grown on a crystalline substrate, with a buffer layer in between (in this case, the top portion of the substrate on the figure is monocrystalline). Here, the substrate 100 is formed by heteroepitaxy of diamond on a material that differs from diamond. In some embodiments, the substrate 100 is formed on scCVD (single-crystal chemical vapor deposition).

On this substrate 100, a first electrode layer 101 is formed by a diamond epitaxy.

This layer 101 is being referred to as an electrode as it is doped. For example, boron (p-type doping) or phosphorus (n-type doping) can be introduced during the diamond epitaxy. It should be noted that the dopant can be introduced at the same time as the precursor for growing the diamond. The diamond lattice being particularly compact, it is too difficult to activate interstitial dopants to become substitutional as a temperature above 2000 °C may be required. Thus, introduction of dopants along with the precursor allows substitution to occur at the same time as the diamond lattice is formed.

The thickness of the first electrode layer 101 can be above 100 nanometers, with a dopant concentration above $1.10^{18}/cm^3$.

It should be noted that preferably, the substrate 100 (or at least the monocrystalline diamond portion) should have the opposite doping type. Also, the substrate 100 can be patterned in a preliminary step, this patterning can be performed by means of selective diamond epitaxy in a hard mask or by a photolithography step using a photosensitive mask, an etching step (for example using a mixture of argon and dioxygen), and a subsequent surface cleaning step (for example using a hot acid, for example sulfuric acid ($H_2SO_4$)). The first electrode layer 110 can match the patterning of the substrate 100.

On the first electrode layer 101, a first intermediate layer 102 has been formed by diamond epitaxy. The intermediate layer 102 is formed in a dielectric diamond material.

After forming the intermediate layer 102 by diamond epitaxy, the intermediate layer shape is modified by etching to obtain an intermediate layer presenting on a first extremity a first thickness and on the second extremity a second thickness, said second thickness being greater than the first thickness.

The etching creates an intermediate layer 102 presenting a first region where the thickness of the layer is constant and equal to the first thickness and a second region where the thickness of the layer is constant and equal to the second thickness and between the two regions, a third region where the thickness increases from the first thickness to the second thickness in a curved shape manner.

Preferentially, as shown on figure 1, the curve is a quarter of the circle. This provides the advantage of minimizing the surface used on the substrate for the design of the electrical device.

Preferentially, the radius of the curve is equal or greater than twice the first thickness.

When we mention first region, second region and third region of the intermediate layer 102, this is just to explain the shape of the intermediate layer but does not represent three different regions having different structures or having been assembled, but a single intermediate layer 102 which shape observed on its side, as in figures 1 to 5; presents this singular shape.

A second electrode layer 103 is formed on the intermediate layer 102 in a conductor material, so that the second electrode layer 103 comprises a shape that conforms with the shape of the intermediate layer located below. This means that the second electrode layer presents a first region 103a, on the intermediate layer 102 first region, parallel to the substrate region 100, a termination region, 103b, on the intermediate layer 102 third region, extending from the first region to the second region in a curved shape. Preferably, the termination region 103b being ended parallel to the first region 103a when the tangent T to the curved shape at the extremity point TP of the termination region 103b is perpendicular to the first region.

Thanks to this configuration, the electrical device can manage the electrode edge regions, also called termination junctions to avoid charge crowding effects. The charge crowding effect is reduced by progressively increasing the distance between the top electrode and the opposite electrode. The progressive increase in distance follows a round shape profile, therefore avoiding the charge crowding effect induced by edges at the termination. The electric field peak induced by the edge of the termination junctions of the prior art disappears with this new geometry of a round shape profile of the termination junctions.

In addition, it is important not only to suppress the edge by the curved shape. Indeed, if the electrode terminates in an region where the charge density is not null, the electric field, being equal to the charge density divided by $\varepsilon$, will diverge and will not be suppressed. In other words, the electric field is by construction directed perpendicular to the electrode. As a consequence, beyond the vertical section of the electrode (i.e. perpendicular to interface) the electric flux across the interface in between the dielectric and the bottom electrode is null in the region.

Therefore, in addition to the curved shape of part of the second electrode, it is also important to terminate the second electrode in a configuration where the charge density is null to avoid the electric field crowding at the termination of the electrode. This can be achieved by terminating the electrode when the tangent to the curved shape at the extremity point TP of the termination region is perpendicular to the first region. The electric field being equal to the charge density divided by $\varepsilon$, when the charge density is null, the electric field is null and therefore the electric field crowding is suppressed. Indeed, if the surface of the electrode is parallel to the electric field, there is no charge density.

Several methods can be foreseen for obtaining a curve shape in the second electrode, such as polishing, masking and plasma etching, masking and selective growth.

According to some embodiments, the curved shape is a round shaped profile and is a quarter of a circle. In other words, the vertical portion of the electrode might be extended beyond a quarter circle toward a direction perpendicular to the interface.

In such a configuration, the space used for the electrode termination is reduced compared to another round shaped profile that would extend more by having a radius which would not be constant.

The first region 103 and the second region 103b can be seen on figure 1b representing a top view of the device.

The first region of the intermediate layer 102 is located below the first region 103a and the third region of the intermediate layer 102 is located below the termination region 103b.

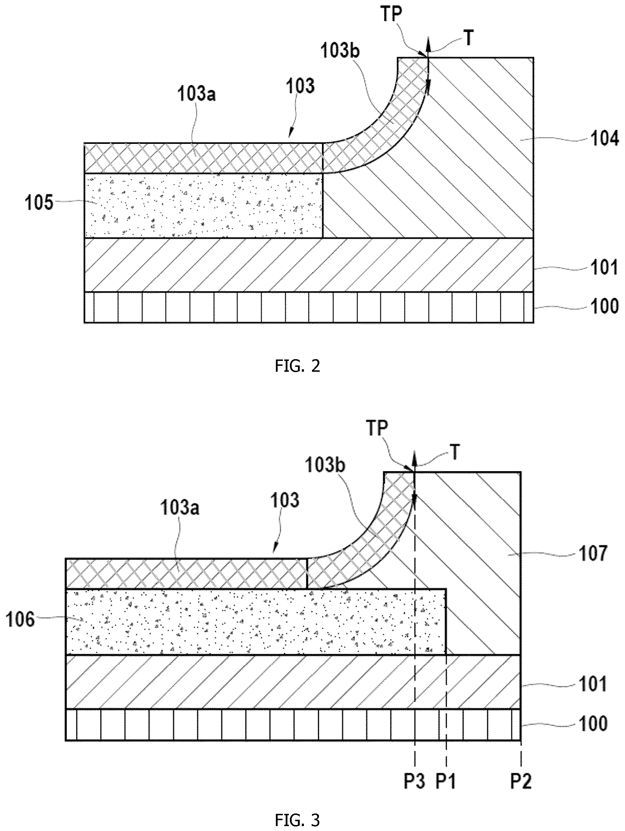

Figure 2 discloses a second embodiment of the present disclosure.

Substrate region 100 and first doped diamond layer 101 are the same as the ones described with respect to figure 1.

a dielectric layer is formed on the first doped diamond layer.

This dielectric layer comprises two adjacent regions, a first intermediate region (also called later layer) 105 and a dielectric region (also called later layer) 104.

The intermediate layer 105 is formed in a dielectric diamond material.

The intermediate layer 105 is formed by diamond epitaxy on at least a first region of the first doped diamond layer 101.

A dielectric material layer 104 is formed by epitaxy on another region of the first diamond layer 101 where the intermediate layer 105 has not been formed. The intermediate layer 105 and the dielectric material layer 104 both recover jointly the first doped diamond layer 101. The dielectric material layer is preferably a non-diamond layer.

When surface conduction provides applicative advantages, for instance in the case the dielectrical device is a lateral diode, it is advantageous to have both dielectric diamond material and non-diamond dielectric material, having a different doping.

A higher dielectric strength material is preferable to withstand the electric field, such as for instance $SiO_2$ (silicon dioxide). The dielectric material acts as a parallel capacitor under the same electric field magnitude as the intermediate layer.

According to this embodiment, an etching of the dielectric layer 104 is performed to obtain a curve in the dielectric layer 104.

In this embodiment, the intermediate layer presents a constant thickness on all its surface. This sickness can be the same as the first thickness observed on figure 1.

The dielectric material layer 104 shape is modified by the etching to obtain a dielectric material layer 104 presenting on a first extremity a first thickness and on the second extremity a second thickness, said second thickness being greater than the first thickness. The extremities here refer to the intersection of the two dielectric layer ending vertical plans (perpendicular to the substrate region) with the first diamond layer 101, or the substrate region 100, both being parallel to each other.

The dielectric material layer has an increasing thickness from said first constant thickness on the intermediate layer (102, 105, 106, 108, 110) side to a second thickness on its other side opposite to the intermediate layer, said increase of thickness having a curved shape.

The first thickness is the thickness of the intermediate layer 105 to obtain a surface continuity between the first intermediate layer 105 and the dielectric material layer 104. Said second thickness can be the same as the second thickness of the intermediate layer 102 of figure 1.

The dielectric material layer 104 presents a top curved-shaped surface between its extremity on the side of the intermediate layer, and an intermediate point on the top of the dielectric material where the thickness is the second thickness, the thickness increasing from the first thickness to the second thickness in a curved-shaped manner.

Preferentially, the curve is a quarter of the circle. This provides the advantage of minimizing the surface used on the substrate for the design of the electrical device.

Preferentially, the radius of the curve is equal or greater than twice the first thickness.

As can be seen, the embodiment of figure 1 represents a specific embodiment of figure 2 where the dielectric material layer is replaced by the intermediate layer. In other words, the intermediate layer covers the whole surface of the first doped diamond layer.

A second electrode layer 103 is formed in a conductor material on the intermediate layer and on the dielectric material, and is doped. The second doped diamond layer comprises a shape that conforms with the shape of the intermediate layer and the dielectric layer located below. This means that the second electrode layer presents also a first region 103a, on the intermediate layer, parallel to the substrate region, and a termination region, 103b, on the dielectric layer, the termination region extending from the first region 103a to the end of the termination region 103b in a curved shape. Preferably, the termination region 103b being ended parallel to the first region 103a when the tangent T to the curved shape at an intermediate point of the termination region 103b is perpendicular to the first region 103a. Said intermediate point TP of the termination region 103b being the intermediate point TP on the top of the dielectric material 104.

Figure 3 discloses a third embodiment of the present disclosure.

Substrate region 100 and first doped diamond layer 101 are the same as the ones described in detail with respect to figure 1.

An intermediate layer 106 is formed by diamond epitaxy on at least a part of the first diamond layer 101. The intermediate layer 106 is formed in a dielectric diamond material.

The intermediate layer 106 extends on the first doped diamond layer 101 parallel to first doped diamond layer 101 towards a first extremity of the first doped diamond layer 101 up to an ending vertical plan P1 located between a vertical plan P2 (perpendicular to the substrate region) comprising a second extremity of the first doped diamond layer 101 and a vertical plan P3 which is perpendicular to the substrate region 100 and which comprises the extremity of the of a curved-shaped termination region of an above second doped diamond layer 103.

A dielectric material layer 107 is formed on a region of the intermediate layer 106 and on the region of the first diamond layer 101 where the intermediate layer 106 has not been formed. The intermediate layer 106 and the dielectric material layer 107 both recover jointly the first doped diamond layer 101. The dielectric layer 106 therefore covers part of the first doped diamond layer 101 and part of the intermediate layer 106.

A high dielectric permittivity material is preferable to withstand the electric field, such as for instance $SiO_2$ (silicium dioxide). The dielectric material acts as a series capacitor sharing the electric field magnitude with the intermediate layer.

According to this embodiment, an etching of the dielectric layer region is performed to obtain a curve in the dielectric material layer 107.

In this embodiment, the intermediate layer 106 presents a constant thickness on all its surface. This sickness can be the same as the first thickness observed on figure 1.

The dielectric material layer 107 is modified by etching. After dry-etching, the dielectric material layer 107 presents a curved-shape from the first doped diamond layer to top of the dielectric material layer.

A second electrode layer 103 is formed in a conductor material on the intermediate layer 106 and on the dielectric material layer 107, so that the second electrode layer 103 comprises a shape that conforms with the shape of the intermediate layer 106 and the dielectric material layer 107 located below. This means that the second electrode layer 103 presents also a first region 103a, on the intermediate layer 106, parallel to the substrate region 100, and a termination region, 103b, on the dielectric material layer 107, the termination region 103b extending from the first region 103a to the end of the termination region 103b in a curved shape. Preferably, the termination region being ended parallel to the first region when the tangent T to the curved shape at the extremity point TP of the termination region is perpendicular to the first region.

Preferentially, the curve is a quarter of the circle. This provides the advantage of minimizing the surface used on the substrate for the design of the electrical device.

Preferentially, the radius of the curve is equal to or greater than twice the first thickness.

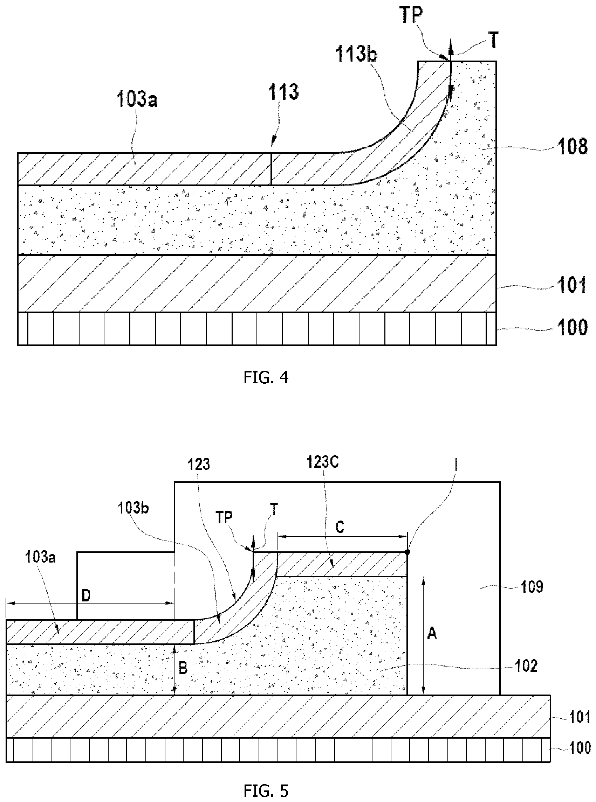

Figure 4 discloses a fourth embodiment of the present disclosure.

Figure 4 represents the embodiment of the figure 1 in which the second doped diamond layer 113 comprises a first region 103a, as disclosed in figure 1 and a second region 113b which is a curved-shaped region. In this embodiment the curved-shaped region 113b is not a quarter of a circle but extends more widely on the intermediate layer 108. However, as in the other embodiments. Preferably, the termination region of the curved shape is ended parallel to the first region 103a when the tangent T to the curved shape at the extremity point TP of the termination region is perpendicular to the first region.

The embodiment of figure 4, in which the curved shape does not present a constant radius, i.e is not a quarter of a circle, is also applicable to the embodiments of figures 2, 3 and 5.

Figure 5 represents a fifth embodiment of the present disclosure.

Substrate region 100, first doped diamond layer 101 and diamond intermediate layer 102 are the same as the ones described in detail with respect to figure 1.

A second doped diamond layer 123 is also formed by epitaxy of diamond on the intermediate layer 102 and modified by dry-etching. The second doped diamond layer 123 comprises also the first region 103a, on the intermediate layer 102, parallel to the substrate region 100, the termination region 103b on the intermediate layer second region, extending from the first region to the second region in a curved shape. Preferably, the termination region 103b being ended parallel to the first region when the tangent T to the curved shape at the extremity point TP of the termination region 103b is perpendicular to the first region.

In this embodiment, the second doped diamond layer 123 comprises a third region 123c, extending the second termination region 123b, and located above the second region of the diamond intermediate layer 102. As the second region of the diamond intermediate layer 102 has a constant thickness, the third region is parallel to the diamond intermediate layer 102. The third region 123c provides also a constant thickness, which is the same thickness as the ones of first region 103a and second region 103b.

In addition, a diamond passivation layer 109 is formed by epitaxy of diamond. The diamond passivation layer 109 is formed above a region of the second doped diamond layer 123, and a region of the first doped diamond layer 101. The diamond passivation layer 109 is obtained in the same material as the diamond intermediate layer102.

More precisely, the diamond passivation layer 109 comprises a first region (or part) having a constant thickness (called third thickness) and located on part of the second doped diamond layer first region 103a. To be more precise, the diamond layer first region 103a comprises a first extremity and a second extremity, said second extremity being the first extremity of the termination region 103b. The diamond passivation layer first region is formed on a part of the first region 103a between the first and second extremities with a constant thickness.

The diamond passivation layer 109 comprises a second region (or part), parallel to the substrate region 100, with a thickness, different and greater than the thickness of its first region, called fourth thickness. This second region extends from the first region and is formed above part of the second doped diamond layer 123, comprising at least said termination region (103b) and said third region (123c) and ends after the extremity of the second doped diamond layer 123, or more precisely the extremity of the third region 123c, on the first diamond layer 101. This is possible because the intermediate layer 102 does not completely cover the first doped diamond layer 101.

The diamond passivation layer 109 allows a crowding effect to take place at the outer edge of the top electrode, point I on the second doped diamond layer 123. Point I remains however in a region of a diamond layer and not in the air as it would be without the passivation layer. If the critical point I would be in the air, it would ionize the air. The present embodiment enables therefore to cover the critical point I by the passivation layer 109 so that the electric field is controlled in a better way than in the air or in a polymer as diamond is a material having a high breakdown voltage, controlled and prone to water absorptions.

In this example, the length A is greater than B and the length D is much greater than C. A is the height of the intermediate layer at point I and B is the height of the first region of the intermediate layer, C is the length of the third region 123c of the second doped diamond layer 123, and D is the length of the first region 103a of the second doped diamond layer 123.

In an embodiment, the breakdown voltage in the first region of the intermediate layer 102 must be controlled and around 9 MV.

The breakdown voltage VbreakB at point B is proportional to the breakdown voltage at point I according to the following formula:

$$V_{breakB} = V_{breakA} * \frac{A}{B}$$

In order to increase the capacitance value formed by the two electrodes, B is expected to be reduced. Increasing A will increase the breakdown voltage $V_{breakB}$, as shown by the above formula.

A great advantage of this fifth embodiment is the manufacturing of such a configuration. Indeed, the electrode termination of the curved shaped region is obtained by an etch step, whereas in embodiments A to 4, there is a need of a planarization step to obtain a termination of the 103b or 113b termination parts so that the tangent T to the curved shape at the extremity point TP of the termination region 103b is perpendicular to the first region.

A passivation layer as disclosed in figure 5 can also be added to embodiments described with reference to figures 1 to 4 and figure 6. The passivation can then be diamond for monolithic approaches (such as figures 1, 4, 6) and oxides for other approaches (figures 2, 3).

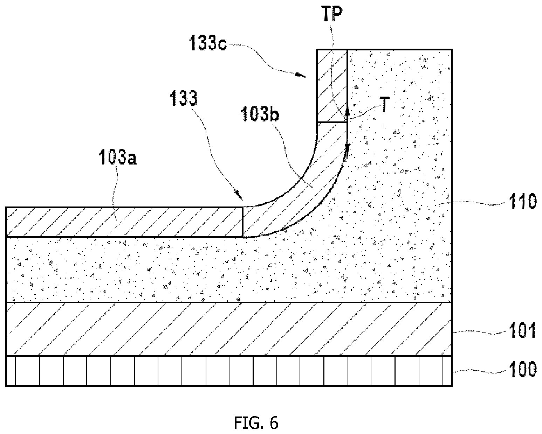

Figure 6 represents a sixth embodiment of the present disclosure.

Substrate region 100, first doped diamond layer 101 are the same as the ones described in detail with respect to figure 1.

A second doped diamond layer 133 is also formed by epitaxy of diamond on the intermediate layer and modified by etching. The second doped diamond layer comprises also the first region 103a, on the intermediate layer 110, parallel to the substrate region 100, the termination region, 103b on the intermediate layer second region, extending from the first region to the second region in a curved shape. Preferably, the termination region being ended parallel to the first region when the tangent T to the curved shape at the extremity point TP of the termination region is perpendicular to the first region.

In this embodiment, the second doped diamond layer 133 comprises a third region 133c, extending vertically (perpendicular to the susbstrate layer 100) the second termination region 103b. Therefore, the thickness of the intermediate layer 110 is greater than the thickness of the intermediate layer 102 on figure 1. Indeed, it comprises in addition the thickness corresponding to the length of the vertical third region 133c.

First, second and third regions form a monolithic region, the decomposition being just given to understand the shape of the second doped diamond region.

In all the above-described embodiments, the intermediate layers 102, 104, 106 and 108 can have a dislocation density comprised between $10^5.cm^{-2}$ to $10^9.cm^{-2}$, and can be doped with a deep level dopant of type n that passivates the dislocations of the intermediate layer.

By way of example, the deep level dopant of type n that passivates the dislocations of the intermediate layer can have a concentration comprised between $1.10^{14}/cm^3$ (atomic) and $1.10^{19}/cm^3$ (atomic).

The deep level dopant of type n can be nitrogen.

The intermediate layers have a lower thickness superior to 0.1 $\mu$m, or preferably superior to 0.5 $\mu$m, or preferably superior to 1 $\mu$m, or even preferably superior to 2 $\mu$m.

It should be noted that the epitaxial steps mentioned herein can be Chemical Vapor Deposition (CVD) or single-crystal vapor deposition (scCVD) homoepitaxy that thickens a monocrystalline diamond region and preserves the monocrystalline nature of the material. However, dislocations are present in the electrode layers and the intermediate layer as the substrate was obtained by heteroepitaxy.

In all the above-described embodiments, the etching can be performed after marking the regions outside of the electric component or at least the regions outside the surface to be etched. Etching can be performed by adjusting an argon-oxygen etching process, to a specific regime that allows us to achieve this etching.

In all the above-described embodiments, the radius of the curved shape (curvature radius) can be proportional to a thickness of the multi-layer device.

In all the above-described embodiments, the curvature radius of the rounded corner can be greater than the thickness of an insulator layer of the multi-layer device.

In all the above-described embodiments, the radius of the curved shape (curvature radius) can be twice the thickness of the intermediate layer.

In all the above-described embodiments, the curvature radius of the rounded corner can be greater than double the thickness of the intermediate layer (referred to first thickness in the present disclosure) of the multi-layer device.

In all the above embodiments, the first electrode and the second electrode can be doped with p-type impurities or n-type impurities. Therefore, the following combinations can be foreseen:
First electrode and second electrode being doped with p-type impurities for realizing a diamond capacitor.

First electrode and second electrode being doped with n-type impurities for realizing a diamond capacitor.

First electrode doped with n-type impurities and second electrode doped with p-type impurities for realizing a diamond diode.

First electrode doped with p-type impurities and second electrode doped with n-type impurities for realizing a diamond diode.

In all the above embodiments, the n-type doping can be achieved by using phosphorus as n polarity doping.

In all the above embodiments, the p-type doping can be achieved by using boron as p polarity doping.

When a diode is formed (one of the two electrodes being doped with n-type impurities and the other one with p-type impurities), the intermediate region can have nitrogen passivated defects with a relatively high density of defects or can be a high quality layer having lower density of defects (close to a nearly dielectric property) and very low residual doping, the doping being either n doping (phosphorus) or p doping (boron).

The device of figures 1 to 6 can withstand high voltages without being damaged (it is reversible). In particular, the device can be used with a voltage applied that exceeds 700 V, or preferably 900 V, or even more preferably 1.2 kV.

In all embodiments, the substrate 100 is formed by heteroepitaxy of diamond on a material that differs from diamond. In some embodiments, the substrate 100 is formed on scCVD (single-crystal chemical vapor deposition).

Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

**Claims**

1. An electrical device comprising,

   - a substrate region (100),
   - a first electrode formed in a first doped diamond layer (101), on the substrate region (100),
   - a dielectric layer (102, 105, 106, 108, 110, 104, 107) on the first doped diamond layer (101) comprising two adjacent regions, a first region called intermediate layer (102, 105, 106, 108, 110) formed in a dielectric diamond material layer and a second region (104, 107) formed in a dielectric material,
   - a second electrode formed in a conductor material layer (103, 113, 123, 133), located on the dielectric layer,

   wherein

   - said first region in the dielectric diamond material having a first constant thickness
   - the second region comprises a dielectric material and has an increasing thickness from said first constant thickness on the intermediate layer (102, 105, 106, 108, 110) side to a second thickness on its other side opposite to the intermediate layer, said increase of thickness having a curved shape,
   - the second electrode (103, 113, 123, 133) comprises a first region (103a) having a first constant thickness above the intermediate layer (102, 105, 106, 108, 110) and a termination region (103b, 113b) extending the first region in a curved shape above the dielectric material.

2. The electrical device of claim 1, wherein the termination region (103b, 113b) is ended parallel to the first region (103a) when the tangent (T) to the curved shape at the extremity point (TP) of the termination region (103b, 113b) is perpendicular to the first region (103a).

3. The electrical device of any of claims 1 or 2 wherein the dielectric material is different from diamond.

4. The electrical device of any of claims 1 or 2 wherein the dielectric material is diamond, the dielectric layer being a monolithic layer comprising diamond and the second electrode is formed in a dopped diamond layer as conductor material.

5. The electrical device of claim 1, wherein the intermediate layer extends on the first doped diamond layer parallel to first doped diamond layer (101) towards the extremity of the first doped diamond layer (101) up to an ending vertical plan (P1) located between

    - a vertical plan (P2) comprising the extremity of the first doped diamond layer (101) and perpendicular to the first doped diamond layer (101) and

      - - a vertical plan (P3) perpendicular to the first doped diamond layer (101) and comprising the extremity of the termination region (103b, 113b).

6. The electrical device of any one of claims 1 to 5, wherein the curved shape is a round shape profile and is a quarter of a circle.

7. The electrical device of claim 6, wherein the radius of the curved shape is twice the thickness of the intermediate layer.

8. The electrical device of any one of claims 1 to 7, wherein the second doped diamond layer (123) comprises a third region (123c) extending from the extremity of the termination region not connected to the first region (103a), parallel to the first doped diamond layer (101), and separated from the first doped diamond layer (101) by said dielectric layer (102, 105, 106, 108, 110, 104, 107).

9. The electrical device of any one of claims 1 to 7, wherein the second doped diamond layer (133) comprises a third region (133c) extending from the extremity of the termination region (103b) not connected to the first region (103a) and perpendicular to the first doped diamond layer (101).

10. The electrical device of any of claims 1 to 9, wherein the second doped diamond layer (123) comprises a third region (123c), extending the second termination region (123b), and located above the second region of the diamond intermediate layer (102).

11. The electrical device of claim 10 and claim 4 comprising a diamond passivation layer comprising

    - a first part located above part of the second doped diamond layer (123) first region (103a) having a third thickness, and
    - a second part extending from the first part, having a fourth thickness greater than the third thickness and formed above part of the second doped diamond layer (123), said part comprising at least said termination region (103b) and said third region (123c) and ending after the extremity of said third region (123c), on the first diamond layer 101.

12. A method of manufacturing an electrical device comprising:

    - obtaining a substrate region (100),
    - forming, by epitaxy, a first electrode in a first doped diamond layer (101) on the substrate region (100),
    - forming, by epitaxy, an intermediate layer (102, 105, 106, 108, 110) of a first thickness on at least a first region of the first doped diamond layer (101),
    - forming, a dielectric layer (104, 107) on at least a second region of the first doped diamond layer (101), of a second thickness greater than the first thickness, joining and extending the intermediate layer (102, 105, 106, 108, 110), said first region and said second region being adjacent,
    - etching the dielectric layer (104, 107), so that the non-diamond dielectric layer (104, 107) has an increasing thickness from said first thickness on the intermediate layer side to a second thickness on its other side, said increase of thickness having a curved shape,
    - forming, a second electrode in a conductor material layer (103, 113, 123, 133) located on the non-diamond dielectric layer (104, 107), so that the second electrode (103, 113, 123, 133) comprises a first region (103a), of a first constant thickness, on the intermediate layer (102, 105, 106, 108, 110), and a termination region (103b), extending the first region (103a) in a curved shape above the dielectric layer (104, 107) , the termination region (103b) being ended parallel to the first region (103a) when the tangent

(T) to the curved shape at the extremity point of the termination region is perpendicular to the first region (103a).

13. A method according to claim 12 wherein the dielectric material is diamond, said second electrode being formed by epitaxy in a dopped diamond layer.

14. A method of using an electrical device in accordance with any one of claims 1 to 10, wherein a voltage applied to the capacitor exceeds 700 V, or preferably 900 V, or even more preferably 1.2 kV.

FIG. 1A

FIG. 1B

TP

T

103b

103

103a

104

105

FIG. 2

101

100

TP

T

103b

103

103a

107

106

101

100

P3 P1 P2

FIG. 3

FIG. 4

FIG. 5

FIG. 6

Europäisches
Patentamt

European
Patent Office

Office européen
des brevets

# EUROPEAN SEARCH REPORT

Application Number

EP 25 30 5032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TWITCHEN D J ET AL: "HIGH-VOLTAGE SINGLE-CRYSTAL DIAMOND DIODES", IEEE TRANSACTIONS ON ELECTRON DEVICES, IEEE, USA, vol. 51, no. 5, 1 May 2004 (2004-05-01), pages 826-828, XP001195254, ISSN: 0018-9383, DOI: 10.1109/TED.2004.826867 | 1,12 | INV. H10D1/00 H10D1/66 H10D1/68 H10D62/83 H10D64/20 |
| Y | * abstract * * line 826 - line 827; figure 1 * | 1-3,5-7, 12,14 | |
| A | | 4,8-11, 13 | |
| Y | MASANORI NAGASE ET AL: "Vertical Diamond Schottky Barrier Diode Fabricated on Insulating Diamond Substrate Using Deep Etching Technique", IEEE TRANSACTIONS ON ELECTRON DEVICES, IEEE, USA, vol. 60, no. 4, 1 April 2013 (2013-04-01), pages 1416-1420, XP011497383, ISSN: 0018-9383, DOI: 10.1109/TED.2013.2247609 | 1-3,5-7, 12,14 | |
| | | | TECHNICAL FIELDS SEARCHED (IPC) |
| A | * abstract * * page 1417, left-hand column; figure 1b * | 4,8-11, 13 | H10D |
| A | BLICHER A ET AL: "REVIEW ARTICLE; Physics of semiconductor power devices", REPORTS ON PROGRESS IN PHYSICS, INSTITUTE OF PHYSICS PUBLISHING, BRISTOL, GB, vol. 45, no. 4, 1 April 1982 (1982-04-01), pages 427-468, XP020024746, ISSN: 0034-4885, DOI: 10.1088/0034-4885/45/4/002 * page 449; figure 25 * | 1-14 | |

-/--

The present search report has been drawn up for all claims

| Place of search | Date of completion of the search | Examiner |
|---|---|---|
| Munich | 20 June 2025 | Nesso, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

**Application Number**

EP 25 30 5032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BALIGA B. JAYANT: "High-voltage device termination techniques a comparative review", IEE PROCEEDINGS I (SOLID-STATE AND ELECTRON DEVICES), vol. 125, no. 5, 1 October 1982 (1982-10-01), pages 173-179, XP093263350, ISSN: 0143-7100, DOI: 10.1049/ip-i-1.1982.0037 * abstract * * page 175; figure 3 * ----- | 1-14 | |
| | | | **TECHNICAL FIELDS SEARCHED (IPC)** |

The present search report has been drawn up for all claims

| Place of search | Date of completion of the search | Examiner |
|---|---|---|
| Munich | 20 June 2025 | Nesso, Stefano |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)